# EUROPEAN PATENT APPLICATION

(11) **EP 3 799 541 A1**
(43) Date of publication of application: **31.03.2021**
(21) Application number: 19807426.2
(22) Date of filing: 24.04.2019
(51) Int. Cl.: H05K 3/04, H05K 3/06

(54) **METHOD FOR MANUFACTURING CIRCUIT BOARD**

(30) Priority: 23.05.2018 JP 2018098518
(71) Applicant: Sumitomo Bakelite Co.Ltd., Shinagawa-ku Tokyo 140-0002 (JP)
(72) Inventor: YAGI Shigeyuki, Tokyo 140-0002 (JP); HAMAYA Kazuya, Tokyo 140-0002 (JP)
(74) Representative: Ter Meer Steinmeister & Partner
(86) International application number: PCT/JP2019/017418
(87) International publication number: WO 2019/225273

(57) **Abstract**

First, a router (400) is rotated about a shaft (406) to cause a tip end (402) of the router (400) to move in a vertical direction with respect to a conductive layer (130) while being in contact with the conductive layer (130). In this way, the router (400) is inserted into the conductive layer (130) to form an opening in the conductive layer (130). Next, the router (400) is rotated about the shaft (406) to cause a side surface (404) of the router (400) to move in a horizontal direction with respect to the conductive layer (130) while being contact with the conductive layer (130). In this way, the conductive layer (130) is formed into a conductive pattern (132).

## Description

### TECHNICAL FIELD

The present invention relates to a method of manufacturing a circuit board.

### BACKGROUND ART

In recent years, circuit boards for mounting power modules have been developed. A circuit board has a conductive pattern. Various semiconductor devices (for example, semiconductor chips) are mounted on the conductive pattern of the circuit board. The conductive pattern forms a circuit.

Patent Document 1 describes an example of a method of manufacturing a circuit board. In Patent Document 1, the circuit board is formed from a substrate having a conductive layer. Patent Document 1 describes that the conductive layer is etched to form the conductive layer into a conductive pattern.

### RELATED DOCUMENT

### PATENT DOCUMENT

[Patent Document 1] International Publication No. WO2011/034075

### SUMMARY OF THE INVENTION

### TECHNICAL PROBLEM

As one of the indices of the performance of a circuit board, there is verticality (for example, etching factor) of a sidewall of a conductive pattern. The present inventor found that the etching of Patent Document 1 cannot realize good verticality due to an undercut of the sidewall of the conductive layer.

An object of the present invention is to improve the verticality of a sidewall of a conductive pattern.

### SOLUTION TO PROBLEM

According to the present invention, there is provided a method of manufacturing a circuit board, including:
a step of preparing a substrate having a conductive layer; and
a step of cutting the conductive layer to form the conductive layer into a conductive pattern.

### ADVANTAGEOUS EFFECTS OF INVENTION

According to the present invention, the verticality of the sidewall of the conductive pattern can be improved.

### BRIEF DESCRIPTION OF THE DRAWINGS

The above and other objects, features and advantages will be more apparent from the following description of preferred embodiments taken in conjunction with the accompanying drawings.

Fig. 1 is a diagram illustrating an electronic device according to a first embodiment.
Fig. 2(a) is a diagram for describing an example of a method of manufacturing a circuit board illustrated in Fig. 1, and Fig. 2(b) is a diagram for describing the example of the method of manufacturing a circuit board illustrated in Fig. 1.
Fig. 3 is a diagram for describing an example of details of a method of forming a conductive layer into a conductive pattern.
Fig. 4 is a diagram for describing an example of details of a method of adjusting the position of a router in a vertical direction with respect to the conductive layer.
Fig. 5 is a diagram for describing an example of details of a method of forming respective conductive patterns of a plurality of substrates.
Fig. 6(a) is a diagram for describing an example of a method of manufacturing a circuit board according to a second embodiment, Fig. 6(b) is a diagram for describing the example of the method of manufacturing a circuit board according to the second embodiment, and Fig. 6(c) is a diagram for describing the example of the method of manufacturing a circuit board according to the second embodiment.
Fig. 7(a) is a diagram illustrating an example of a cross section of a conductive pattern formed by the method according to the second embodiment, and Fig. 7(b) is a diagram illustrating an example of a cross section of a conductive pattern formed by a method according to a comparative example.
Fig. 8(a) is a diagram for describing an example of a method of manufacturing a circuit board according to a third embodiment, Fig. 8(b) is a diagram for describing an example of the method of manufacturing a circuit board according to the third embodiment, and Fig. 8(c) is a diagram for describing an example of the method of manufacturing a circuit board according to the third embodiment.
Fig. 9 is a diagram illustrating an electronic device according to a fourth embodiment.

### DESCRIPTION OF EMBODIMENTS

Hereinafter, embodiments of the present invention will be described with reference to the drawings. Note that, in all drawings, like constituent elements are denoted by like reference numerals, and the description thereof will not be repeated.

### (First Embodiment)

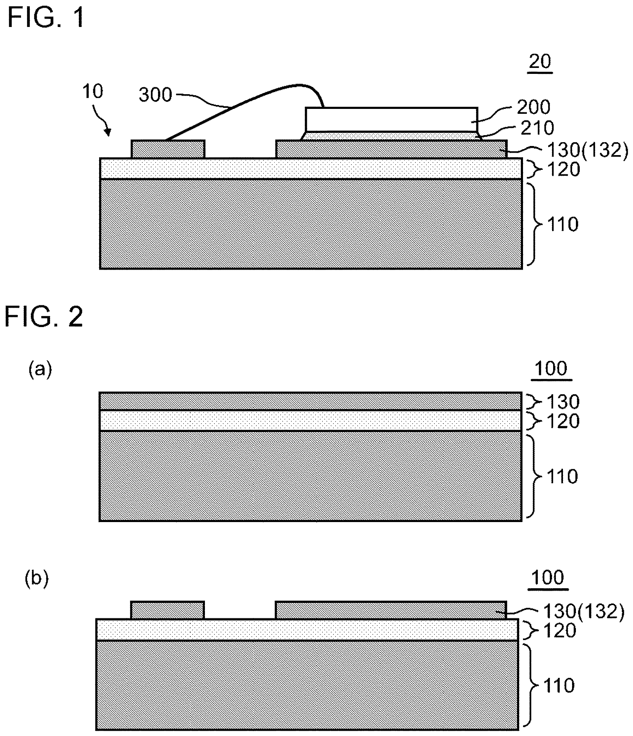

Fig. 1 is a diagram illustrating an electronic device 20 according to a first embodiment.

The electronic device 20 includes a circuit board 10, a semiconductor chip 200, an adhesive layer 210, and a bonding wire 300.

The circuit board 10 includes a base layer 110, an insulating layer 120, and a conductive layer 130. The conductive layer 130 serves as a conductive pattern 132 and forms a circuit.

The semiconductor chip 200 is mounted on a part of the conductive pattern 132 through the adhesive layer 210. The semiconductor chip 200 is, for example, a power module (for example, a silicon chip).

The bonding wire 300 electrically connects the semiconductor chip 200 to another part of the conductive pattern 132.

Figs. 2(a) and 2(b) are diagrams for describing an example of a method of manufacturing the circuit board 10 illustrated in Fig. 1. In this example, the circuit board 10 illustrated in Fig. 1 is manufactured as follows.

First, as illustrated in Fig. 2(a), a substrate 100 is prepared. The substrate 100 has the conductive layer 130.

Next, as illustrated in Fig. 2(b), the conductive layer 130 is cut to form the conductive layer 130 into the conductive pattern 132.

According to the example illustrated in Figs. 2(a) and 2(b), the verticality of the sidewall of the conductive pattern 132 can be improved. Specifically, in this example, it is not necessary to form all sidewalls of the conductive pattern 132 by etching (for example, wet etching). Therefore, an undercut on the sidewall of the conductive layer 130 (conductive pattern 132) can be suppressed. Therefore, the verticality of the sidewall of the conductive pattern 132 can be improved.

The example illustrated in Figs. 2(a) and 2(b) is particularly effective from the following aspects in a case where the thickness of the conductive layer 130 before cutting the conductive layer 130 is large, for example, more than or equal to 0.20 mm, more than or equal to 0.50 mm, or more than or equal to 1.00 mm.

In the first aspect, according to the example illustrated in Figs. 2(a) and 2(b), an undercut of the sidewall of the conductive layer 130 (conductive pattern 132) can be suppressed. The undercut due to etching becomes more significant as the thickness of the conductive layer 130 increases. In the example illustrated in Figs. 2(a) and 2(b), it is not necessary to form all sidewalls of the conductive pattern 132 by etching even in a case where the thickness of the conductive layer 130 is large. Therefore, an undercut on the sidewall of the conductive layer 130 (conductive pattern 132) can be suppressed.

In the second aspect, according to the example illustrated in Figs. 2(a) and 2(b), a process for forming the conductive pattern 132 can be simplified at a low cost. If all sidewalls of the conductive pattern 132 are formed by etching in a case where the thickness of the conductive layer 130 is large, there may be cases where it is necessary to perform etching a plurality of times. The plurality of times of etching can make the process for forming the conductive pattern 132 costly and complex. On the other hand, in the example illustrated in Figs. 2(a) and 2(b), it is not necessary to perform etching a plurality of times. Therefore, the process for forming the conductive pattern 132 can be simplified at a low cost.

The method according to the example illustrated in Figs. 2(a) and 2(b) may include a step of removing the conductive layer cut from the substrate 100, from the substrate 100. In an example, while cutting the conductive layer 130, the conductive layer cut from the substrate 100 may be removed from the substrate 100 by, for example, blasting. In another example, after cutting the conductive layer 130, the conductive layer cut from the substrate 100 may be removed from the substrate 100 by, for example, blasting or a chemical treatment (for example, etching).

Details of the substrate 100 will be described with reference to Figs. 2(a) and 2(b).

The substrate 100 includes the base layer 110, the insulating layer 120, and the conductive layer 130 in this order.

The base layer 110 contains a metal (for example, copper or aluminum). The base layer 110 may have the largest thickness among the base layer 110, the insulating layer 120, and the conductive layer 130. In an example, the thickness of the base layer 110 can be more than or equal to 0.5 mm and less than or equal to 3.0 mm.

The insulating layer 120 contains an insulating material having a high thermal conductivity (for example, boron nitride, or alumina). Due to the high thermal conductivity, the insulating layer 120 has excellent heat dissipation. Therefore, heat generated on the conductive layer 130 side (for example, the semiconductor chip 200 illustrated in Fig. 1) can be released to the base layer 110 side through the insulating layer 120. The insulating layer 120 may have the smallest thickness among the base layer 110, the insulating layer 120, and the conductive layer 130. In an example, the thickness of the insulating layer 120 can be more than or equal to 100 µm and less than or equal to 200 µm.

The conductive layer 130 contains a metal (for example, copper or aluminum). The metal contained in the conductive layer 130 may be the same as or different from the metal contained in the base layer 110.

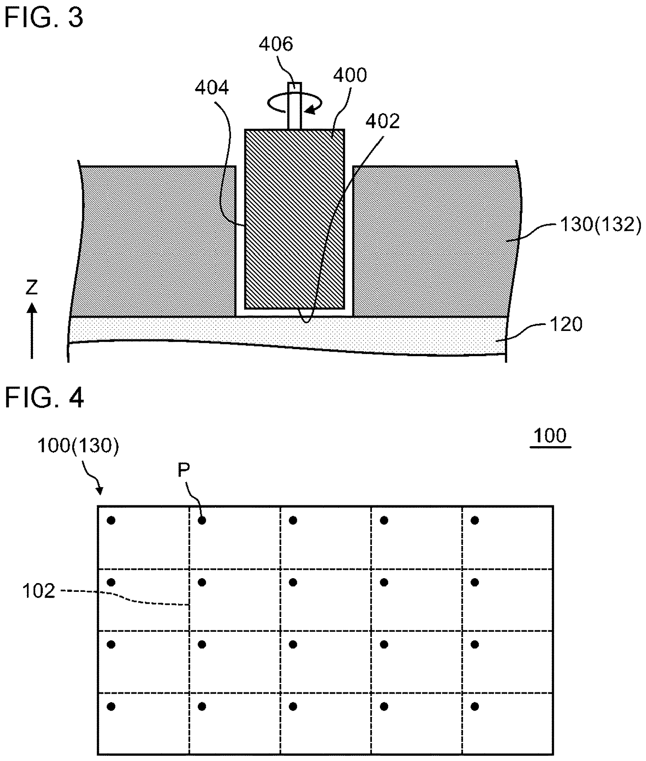

Fig. 3 is a diagram for describing an example of details of a method of forming the conductive layer 130 into the conductive pattern 132.

In the example illustrated in Fig. 3, the conductive layer 130 is cut by a router 400. The router 400 has a tip end 402 and a side surface 404. The router 400 is rotatable about a shaft 406.

In an example, the conductive layer 130 can be cut using the router 400 as follows. First, the router 400 is rotated about the shaft 406 to cause the tip end 402 of the router 400 to move in a vertical direction (Z direction in Fig. 3) with respect to the conductive layer 130 while being in contact with the conductive layer 130. In this way, the router 400 is inserted into the conductive layer 130 to form an opening in the conductive layer 130. Next, the router 400 is rotated about the shaft 406 to cause the side surface 404 of the router 400 to move in a horizontal direction (direction orthogonal to the Z direction in Fig. 3) with respect to the conductive layer 130 while being in contact with the conductive layer 130. In this way, the conductive layer 130 is formed into the conductive pattern 132.

In the example described above, the tip end 402 of the router 400 may be brought into contact with the insulating layer 120, in other words, a part of the surface of the insulating layer 120 may be cut. Even if a part of the surface of the insulating layer 120 is cut, a short circuit between the conductive layer 130 and the base layer 110 (Fig. 1) can be prevented unless the insulating layer 120 is passed through by the router 400.

Fig. 4 is a diagram for describing an example of details of a method of adjusting the position of the router 400 (Fig. 3) in the vertical direction (Z direction in Fig. 3) with respect to the conductive layer 130.

In the first example, the position of the router 400 (Fig. 3) in the vertical direction (Z direction in Fig. 3) with respect to the conductive layer 130 can be adjusted according to an average surface height of the conductive layer 130 at a plurality of positions P in the substrate 100. The surface height of the conductive layer 130 at each position P can be determined by, for example, the relative height of the upper surface of the conductive layer 130 at each position P with respect to a horizontal plane. The surface height of the conductive layer 130 at each position P varies, for example, due to the curvature of the substrate 100 or the variation of each layer (the base layer 110, the insulating layer 120, or the conductive layer 130 illustrated in Fig. 2(a)) in the substrate 100. According to the above-described example, even if the surface height of the conductive layer 130 at each position P varies, the router 400 can be inserted into the conductive layer 130 by an appropriate depth.

In the second example, the position of the router 400 (Fig. 3) in the vertical direction (Z direction in Fig. 3) with respect to the conductive layer 130 can be adjusted according to the average thickness of the conductive layer 130 at a plurality of positions P in the substrate 100. According to this example, even if the thickness of the conductive layer 130 at each position P varies, the router 400 can be inserted into the conductive layer 130 by an appropriate depth.

In the example illustrated in Fig. 4, the substrate 100 has a plurality of regions 102. The plurality of regions 102 are arranged in a two-dimensional matrix, and in the example illustrated in Fig. 4, are arranged in a matrix of four rows and five columns. The plurality of positions P are respectively located in the plurality of regions 102, and in the example illustrated in Fig. 4, are located at the same position in the regions 102. In an example, the same conductive pattern 132 (for example, Fig. 1) may be formed in each region 102. In this case, a plurality of circuit boards 10 having the same conductive pattern 132 can be obtained from the single substrate 100 by dividing the substrate 100 into a plurality of parts respectively including the regions 102. In another example, different conductive patterns 132 (for example, Fig. 1) may be formed in the regions 102. Also in this example, a plurality of circuit boards 10 can be obtained from the single substrate 100 by dividing the substrate 100 into a plurality of parts respectively including the regions 102.

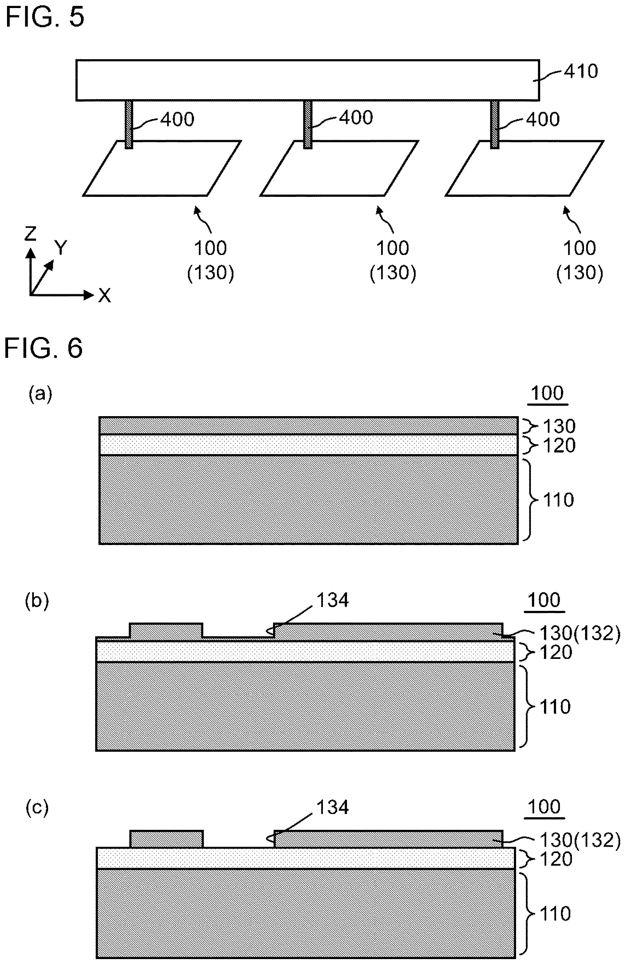

Fig. 5 is a diagram for describing an example of details of a method of forming respective conductive patterns 132 (for example, Fig. 1) of the plurality of substrates 100.

In the example illustrated in Fig. 5, a plurality of routers 400 are prepared. The plurality of routers 400 are for forming the respective conductive patterns 132 (for example, Fig. 1) of the plurality of substrates 100. The plurality of routers 400 are connected to each other by a connecting unit 410.

The plurality of routers 400 are movable in conjunction with each other in the horizontal direction (direction along a plane including an X direction and a Y direction in Fig. 5) with respect to the respective conductive layers 130 of the plurality of substrates 100. According to this configuration, by moving the plurality of routers 400 in conjunction with each other in the horizontal direction with respect to the conductive layers 130, and conductive patterns having the same shape can be respectively formed on the plurality of substrates 100 easily.

The plurality of routers 400 are movable independently of each other in the vertical direction (Z direction in Fig. 5) with respect to the respective conductive layers 130 of the plurality of substrates 100. According to this configuration, by moving the plurality of routers 400 independently of each other in the vertical direction with respect to the conductive layers 130, and each of the plurality of routers 400 can be inserted into the conductive layer 130 by an appropriate depth according to the substrate 100 corresponding to the router 400.

### (Second Embodiment)

Figs. 6(a), 6(b), and 6(c) are diagrams for describing an example of a method of manufacturing the circuit board 10 according to a second embodiment. The example illustrated in Figs. 6(a), 6(b), and 6(c) is the same as the example illustrated in Figs. 2(a) and 2(b), except for the following points.

First, as illustrated in Fig. 6(a), the substrate 100 is prepared in the same manner as in the example illustrated in Fig. 2(a).

Next, as illustrated in Fig. 6(b), the conductive layer 130 is cut to form the conductive layer 130 into the conductive pattern 132. The cutting of the conductive layer 130 can be performed by the router 400, for example, as described with reference to Fig. 3. In the example illustrated in Fig. 6(b), a groove 134 formed in the conductive layer 130 by the cutting does not pass through the conductive layer 130. That is, a part of the conductive layer 130 remains under the bottom surface of the groove 134. The thickness of the conductive layer 130 under the bottom surface of the groove 134 is sufficiently smaller than the thickness of the conductive layer 130 at a position where the groove 134 is not formed, and for example, may be 10% or less of the thickness of the conductive layer 130 at the position where the groove 134 is not formed.

Next, as illustrated in Fig. 6(c), the conductive layer 130 is etched. For the etching of the conductive layer 130, for example, wet etching can be used. By the etching, the conductive layer 130 (Fig. 6(b)) under the bottom surface of the groove 134 is removed. In this way, parts of the conductive pattern 132 are electrically insulated from each other by the groove 134.

According to the example illustrated in Figs. 6(a), 6(b), and 6(c), cutting of the insulating layer 120 due to the cutting of the conductive layer 130 can be suppressed. Specifically, when the groove 134 is passed through the conductive layer 130 only by the cutting of the conductive layer 130, for example, the tip end 402 of the router 400 illustrated in Fig. 3 is brought into contact with the insulating layer 120 and cuts the insulating layer 120. Contrary to this, according to the above-described example, for example, even if the router 400 illustrated in Fig. 3 is used, the tip end 402 of the router 400 is not brought into contact with the insulating layer 120. Therefore, the cutting of the insulating layer 120 due to the cutting of the conductive layer 130 can be suppressed.

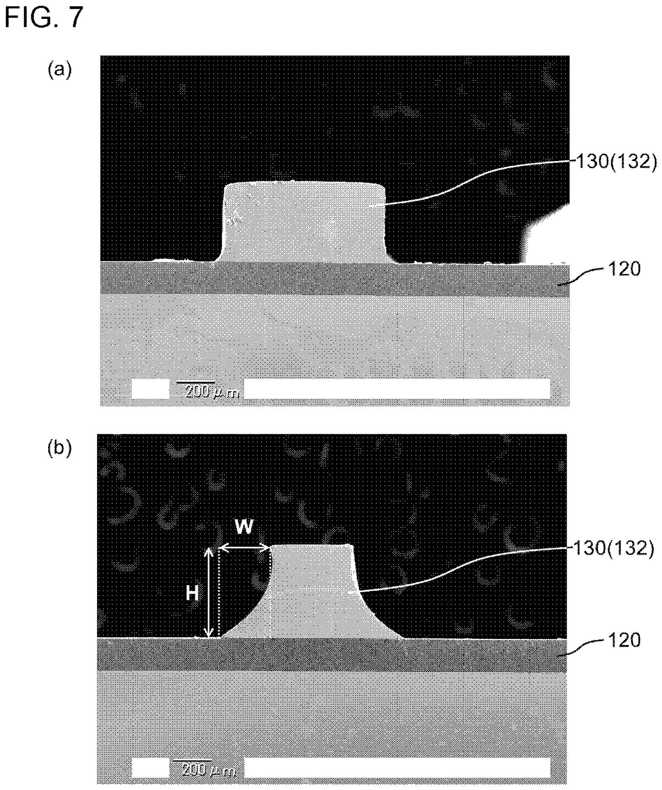

Fig. 7(a) is a diagram illustrating an example of a cross section of the conductive pattern 132 formed by the method according to the second embodiment (the method illustrated in Figs. 6(a), 6(b), and 6(c)). Fig. 7(b) is a diagram illustrating an example of a cross section of the conductive pattern 132 formed by a method according to a comparative example.

The method according to the comparative example is the same as the method according to the second embodiment except that the conductive layer 130 is formed into the conductive pattern 132 by etching without using cutting.

As illustrated in Fig. 7(b), in the comparative example, a large curvature is formed on the sidewall of the conductive pattern 132. This curvature is due to an undercut caused by a difference in etching rate in a thickness direction of the conductive layer 130. In the example illustrated in Fig. 7(b), a sufficiently high etching factor (H/W in Fig. 7(b)) is not obtained, and the sidewall of the conductive pattern 132 does not have good verticality.

Contrary to this, as illustrated in Fig. 7(a), in the second embodiment, a large curvature similar to the curvature illustrated in Fig. 7(b) is not formed on the sidewall of the conductive pattern 132. In the second embodiment, it is not necessary to form all sidewalls of the conductive pattern 132 by etching (for example, wet etching). Therefore, an undercut on the sidewall of the conductive layer 130 (conductive pattern 132) can be suppressed. Therefore, the verticality of the sidewall of the conductive pattern 132 can be improved.

### (Third Embodiment)

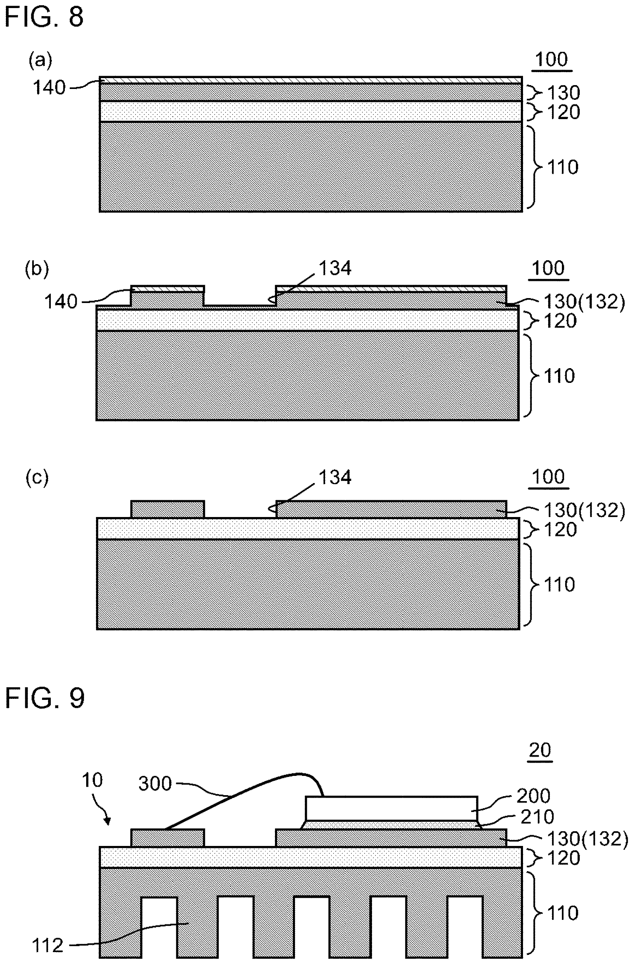

Figs. 8(a), 8(b), and 8(c) are diagrams for describing an example of a method of manufacturing the circuit board 10 according to a third embodiment. The example illustrated in Figs. 8(a), 8(b), and 8(c) is the same as the example illustrated in Figs. 6(a), 6(b), and 6(c), except for the following points.

First, as illustrated in Fig. 8(a), the conductive layer 130 is covered with a mask 140. The mask 140 has resistance to etching in Fig. 8(c), which will be described later, and is, for example, a resist film.

Next, as illustrated in Fig. 8(b), the mask 140 is cut together with the conductive layer 130. In the example illustrated in Fig. 8(b), similar to the example illustrated in Fig. 6(b), the groove 134 formed in the conductive layer 130 by the cutting does not pass through the conductive layer 130.

Next, as illustrated in Fig. 8(c), the conductive layer 130 is etched in a state where the mask 140 covers the conductive layer 130. In this way, parts of the conductive pattern 132 are electrically insulated from each other by the groove 134.

Then, the mask 140 is removed.

According to the example illustrated in Figs. 8(a), 8(b), and 8(c), it is possible to suppress the etching of the conductive layer 130 at the position where the groove 134 is not formed. Specifically, in a case where the conductive layer 130 at the position where the groove 134 is not formed is not covered with the mask 140, the conductive layer 130 at the position where the groove 134 is not formed may also be etched by the etching of the conductive layer 130 under the bottom surface of the groove 134. Contrary to this, according to the example described above, the conductive layer 130 at the position where the groove 134 is not formed can be protected from the etching by the groove 134. In this way, the etching of the conductive layer 130 at the position where the groove 134 is not formed can be suppressed.

### (Fourth Embodiment)

Fig. 9 is a diagram illustrating the electronic device 20 according to a fourth embodiment. The electronic device 20 illustrated in Fig. 9 is the same as the electronic device 20 illustrated in Fig. 1 except for the following point.

The base layer 110 has a plurality of fins 112. Therefore, the base layer 110 can function as a heat sink.

The fins 112 of the base layer 110 can be formed by cutting the base layer 110 in the same manner as the conductive pattern 132 of the conductive layer 130. The cutting of the base layer 110 can be performed by, for example, the router 400 as described with reference to Fig. 3.

While the embodiments of the present invention have been described above with reference to the drawings, these are examples of the present invention, and various configurations other than the above may be adopted.

This application claims priority on the basis of Japanese Patent Application No. 2018-098518 filed on May 23, 2018, and incorporates all of its disclosures herein.

## Claims

1. A method of manufacturing a circuit board, comprising:
a step of preparing a substrate having a conductive layer; and
a step of cutting the conductive layer to form the conductive layer into a conductive pattern.

2. The method of manufacturing a circuit board according to claim 1,
wherein the step of forming the conductive layer into the conductive pattern includes a step of etching the conductive layer after cutting the conductive layer.

3. The method of manufacturing a circuit board according to claim 2,
wherein the step of preparing the substrate having the conductive layer includes a step of covering the conductive layer with a mask,
the step of forming the conductive layer into the conductive pattern includes
a step of cutting the mask together with the conductive layer, and
a step of etching the conductive layer in a state where the mask covers the conductive layer, after cutting the conductive layer and the mask.

4. The method of manufacturing a circuit board according to any one of claims 1 to 3,
wherein the step of forming the conductive layer into the conductive pattern includes a step of moving a router in a horizontal direction with respect to the conductive layer while being in contact with the conductive layer.

5. The method of manufacturing a circuit board according to claim 4,
wherein the step of forming the conductive layer into the conductive pattern includes a step of adjusting a position of the router in a vertical direction with respect to the conductive layer according to an average surface height or an average thickness of the conductive layer at a plurality of positions in the substrate.

6. The method of manufacturing a circuit board according to claim 5,
wherein the substrate has a plurality of regions in which the plurality of positions are respectively located, and
the method of manufacturing a circuit board further comprises a step of dividing the substrate into a plurality of parts respectively including the plurality of regions.

7. The method of manufacturing a circuit board according to any one of claims 4 to 6,
wherein the step of preparing the substrate includes a step of preparing a plurality of substrates respectively having conductive layers,
the step of cutting the conductive layer to form the conductive layer into the conductive pattern includes a step of preparing a plurality of routers for cutting the respective conductive layers of the plurality of substrates,
the plurality of routers are movable in conjunction with each other in the horizontal direction with respect to the respective conductive layer of the plurality of substrates, and
the plurality of routers are movable in the vertical direction independently of each other with respect to the respective conductive layers of the plurality of substrates.

8. The method of manufacturing a circuit board according to any one of claims 1 to 7, further comprising:
a step of removing the conductive layer cut from the substrate, from the substrate.

9. The method of manufacturing a circuit board according to any one of claims 1 to 8,
wherein a thickness of the conductive layer before cutting the conductive layer is 0.20 mm or more.

10. The method of manufacturing a circuit board according to any one of claims 1 to 9,
wherein the conductive layer contains copper or aluminum.

11. The method of manufacturing a circuit board according to any one of claims 1 to 10,
wherein the substrate has a base layer on a side opposite the conductive layer, and
the method of manufacturing a circuit board further comprises a step of cutting the base layer of the substrate to form a fin.
